(19) **Europäisches Patentamt / European Patent Office / Office européen des brevets**

(11) **EP 3 356 840 B1**

(12) **FASCICULE DE BREVET EUROPEEN**

(45) Date de publication et mention de la délivrance du brevet:
**27.04.2022 Bulletin 2022/17**

(21) Numéro de dépôt: **16770786.8**

(22) Date de dépôt: **27.09.2016**

(51) Classification Internationale des Brevets (IPC):
**G01S 3/18** *(2006.01)*   **G01R 29/08** *(2006.01)*

(52) Classification Coopérative des Brevets (CPC):
**G01R 29/08; G01S 3/18**

(86) Numéro de dépôt international:
**PCT/EP2016/072941**

(87) Numéro de publication internationale:
**WO 2017/055257 (06.04.2017 Gazette 2017/14)**

(54) **PROCÉDÉ DE DÉTERMINATION DE CARACTÉRISTIQUES D'UNE ONDE ÉLECTROMAGNÉTIQUE**

VERFAHREN ZUR BESTIMMUNG VON EIGENSCHAFTEN EINER ELEKTROMAGNETISCHEN WELLE

METHOD FOR DETERMINING CHARACTERISTICS OF AN ELECTROMAGNETIC WAVE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.09.2015 FR 1502023**

(43) Date de publication de la demande:
**08.08.2018 Bulletin 2018/32**

(73) Titulaire: **Thales**
**92400 Courbevoie (FR)**

(72) Inventeurs:
• **QUELLEC, Jean-Michel**
  **29238 Brest Cedex 2 (FR)**
• **CHRISTIEN, Daniel**
  **29238 Brest Cedex 2 (FR)**
• **JAHAN, Daniel**
  **29238 Brest Cedex 2 (FR)**

(74) Mandataire: **Lavoix**
**2, place d'Estienne d'Orves**
**75441 Paris Cedex 09 (FR)**

(56) Documents cités:
**WO-A1-2010/136409     US-A1- 2006 087 475
US-A1- 2010 090 900     US-A1- 2012 086 605
US-B2- 8 884 810**

**Description**

La présente invention concerne un procédé de détermination selon le préambule de la revendication 1.

Dans le domaine de la guerre électronique, la détection et la localisation de sources d'émissions électromagnétiques sont des étapes déterminantes pour l'établissement d'une situation tactique ou l'autoprotection.

Pour localiser de telles sources, la radiogoniométrie d'amplitude est une technique couramment utilisée. La radiogoniométrie d'amplitude consiste à déterminer la direction d'arrivée d'une onde reçue par un réseau d'antennes, à partir des puissances délivrées par chacune des antennes illuminées par l'onde. La direction d'arrivée d'une onde est la direction dans laquelle se trouve la source depuis laquelle l'onde a été émise. Le réseau d'antennes comprend des antennes directives, généralement orientées les unes par rapport aux autres de sorte à couvrir intégralement le domaine angulaire à surveiller.

Pour améliorer la précision des valeurs de direction d'arrivée obtenues par radiogoniométrie d'amplitude, il est connu d'augmenter le nombre d'antennes du réseau d'antennes.

Toutefois, pour des raisons de complexité matérielle et donc de coût, le nombre d'antennes d'un réseau d'antennes est généralement limité à six ou huit antennes.

Une technique additionnelle pour améliorer la précision des valeurs de direction d'arrivée obtenues par radiogoniométrie d'amplitude, consiste à réaliser un étalonnage de la puissance délivrée par chaque antenne en fonction de la fréquence de l'onde reçue.

Cependant, la précision des valeurs de directions d'arrivée obtenues peut encore être améliorée.

Un but de l'invention est d'améliorer la précision dans la détermination de la direction d'arrivée d'une onde électromagnétique reçue par un réseau d'antennes ayant un nombre fixé d'antennes.

A cet effet, l'invention a pour objet un procédé de détermination du type précité et selon la partie caractérisante de la revendication 1.

Suivant des modes de mise en oeuvre particuliers, le procédé de détermination comprend une ou plusieurs des caractéristiques des revendications 2 à 8, prises isolément ou suivant toutes les combinaisons techniquement possibles.

L'invention concerne aussi un dispositif de détermination selon la revendication 9.

D'autres caractéristiques et avantages de l'invention apparaîtront à la lecture de la description qui suit de modes de réalisation de l'invention, donnée à titre d'exemple uniquement et en référence aux dessins qui sont :

- figure 1, une vue schématique d'un exemple d'un dispositif de détermination de caractéristiques d'une onde électromagnétique,
- figure 2, un organigramme d'un premier exemple de mise en œuvre d'un procédé de détermination de caractéristiques d'une onde électromagnétique, et
- figure 3, un organigramme d'un deuxième exemple de mise en œuvre d'un procédé de détermination de caractéristiques d'une onde électromagnétique.

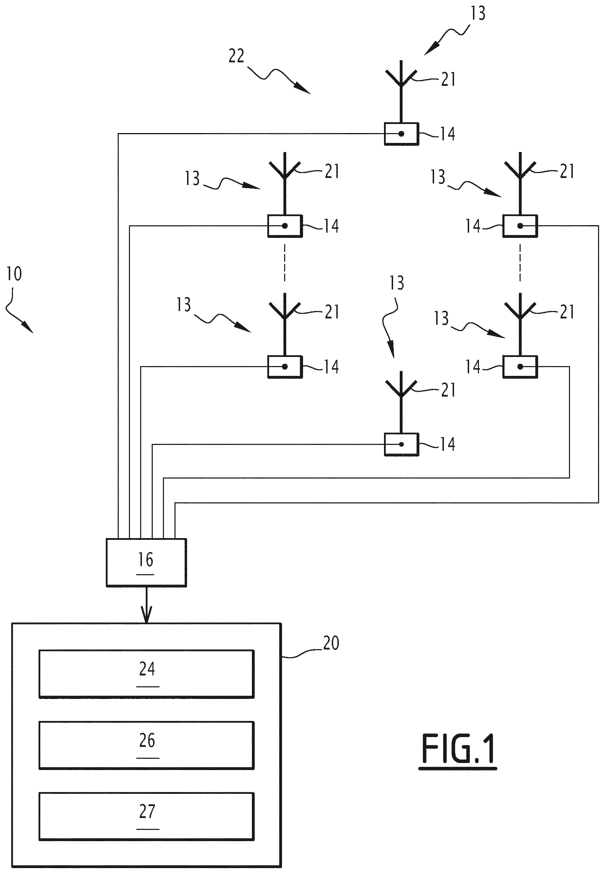

Un dispositif 10 de détermination de caractéristiques d'une onde électromagnétique est illustré par la figure 1. Les caractéristiques de l'onde à déterminer sont la fréquence, la puissance rayonnée, la direction d'arrivée et la polarisation de l'onde. La puissance rayonnée est la puissance ramenée devant un réseau d'antennes, il s'agit d'une PIRE ou puissance isotrope rayonnée effective.

Le dispositif 10 comprend un système de réception 22 formé d'au moins deux voies de réception 13, un déclencheur 16 et une unité de traitement 20.

Dans le mode de réalisation illustré par la figure 1, le dispositif 10 comprend six voies de réception 13.

Chaque voie de réception 13 comprend une antenne 21 propre à recevoir des ondes électromagnétiques et une chaîne 14 de réception des ondes reçues sur l'antenne 21.

Les antennes 21 sont des antennes directives, c'est-à-dire qu'elles sont propres à recevoir des ondes électromagnétiques dans une direction privilégiée.

La fréquence d'utilisation des antennes 21 est, par exemple, comprise entre 2 Gigahertz (GHz) et 18 GHz.

Les antennes 21 des voies de réception 13 sont orientées les unes par rapport aux autres de sorte à couvrir intégralement le domaine angulaire à surveiller. Par exemple, dans le mode de réalisation illustré par la figure 1, les six antennes 21 des voies de réception 13 sont orientées les unes par rapport aux autres avec un décalage angulaire régulier de 60 degrés (°) de sorte à couvrir 360° du domaine angulaire à surveiller.

En variante, les antennes 21 sont orientées les unes par rapport aux autres de sorte à couvrir une portion inférieure à 360° d'un domaine angulaire.

La puissance délivrée par chaque antenne 21 correspond à la puissance de l'onde incidente sur l'antenne 21 multipliée par le gain de l'antenne. Le gain de l'antenne est dépendant de la direction de pointage de l'antenne et de la direction d'arrivée de l'onde incidente.

Chaque chaîne de réception 14 est configurée pour traiter les signaux délivrés par l'antenne 21 correspondante quand celle-ci est illuminée par une onde électromagnétique et pour fournir ainsi une valeur représentative de la puissance délivrée par l'antenne 21 correspondante. Les traitements consistent principalement à amplifier les signaux pour les amener à une puissance d'exploitation et, in fine, fournir une valeur de leur puissance, par exemple en numérique.

Dans la suite de la description, chaque valeur représentative de la puissance délivrée par une antenne 21 est appelée valeur mesurée de puissance et est notée $y_{M,n}$, avec n l'indice de la voie de réception, n variant de 1 à 6 pour l'exemple illustré par la figure 1. Les valeurs mesurées de puissance $y_{M,n}$ des voies de réception 13 sont les composantes d'un vecteur de mesure noté $V_M$ et exprimé sous la forme de la fonction (1) suivante :

$$V_M = \left\{ y_{M,n} \right\}_{n=1,...,N} \qquad (1)$$

En outre, les chaînes de réception 14 sont également configurées pour permettre la mesure de la fréquence de l'onde incidente.

Le déclencheur 16 est propre à recevoir la valeur mesurée de puissance $y_{M,n}$ en sortie de chaque voie de réception 13.

Le déclencheur 16 est propre à comparer les valeurs mesurées de puissance $y_{M,n}$ de chaque voie de réception 13 à un seuil de détection.

Le seuil de détection est, notamment, choisi en fonction du rapport signal à bruit requis par la détection.

L'unité de traitement 20 comprend un processeur 24, une mémoire 26 et un système de traitement numérique rapide 27.

Dans la mémoire 26 sont mémorisées les tables d'étalonnage des voies de réception 13 du dispositif 10.

Les tables d'étalonnage comprennent, pour chaque voie de réception 13, des valeurs représentatives de la puissance délivrée par l'antenne 21 de la voie de réception 13, en fonction de valeurs de puissance rayonnée, de valeurs de fréquence, de valeurs de direction d'arrivée et de valeurs de polarisation. Les valeurs de polarisation sont, par exemple, la polarisation verticale et la polarisation horizontale. Les valeurs contenues dans les tables d'étalonnage étant obtenues par des mesures, elles sont de ce fait des valeurs discrètes.

Dans la suite de la description, les valeurs représentatives de la puissance délivrée par l'antenne 21 de chaque voie de réception 13 et en mémoire des tables d'étalonnage sont appelées valeurs étalonnées de puissance. De telles valeurs étalonnées de puissance sont notées $y_{0,n}$, avec n l'indice de la voie de réception, n variant de 1 à 6 pour l'exemple illustré par la figure 1.

De telles valeurs étalonnées de puissance $y_{0,n}$ sont, par exemple, exprimées sous la forme de la fonction (2) suivante :

$$y_{0,n} = y_{0,n}(\theta_i, PR_j, f_k, pol_l) \qquad (2)$$

où n désigne une voie de réception donnée, n variant de 1 à N,
$y_{0,n}$ désigne une valeur étalonnée de puissance obtenue en sortie de la voie de réception n,
$\theta_i$ désigne une direction d'arrivée donnée d'une onde reçue par le système de réception 22, i variant de 1 à I,
$PR_j$ désigne une puissance rayonnée donnée d'une onde reçue par le système de réception 22, j variant de 1 à J,
$f_k$ désigne une fréquence donnée d'une onde reçue par le système de réception 22, k variant de 1 à K, et
$pol_l$ désigne une polarisation donnée d'une onde reçue par le système de réception 22, l variant de 1 à L.

Les tables d'étalonnage sont constituées à partir de l'émission, sur le système de réception 22, d'ondes électromagnétiques ayant chacune un ensemble de caractéristiques connues. L'ensemble des caractéristiques connues pour chaque onde forme un quadruplet de caractéristiques comprenant la puissance rayonnée de l'onde reçue, la fréquence de l'onde reçue, la polarisation de l'onde reçue et la direction d'arrivée de l'onde reçue.

Chaque émission permet d'obtenir un vecteur d'étalonnage $V_E$ ayant pour éléments les valeurs étalonnées de puissance $y_{0,n}$ obtenues pour chaque voie de réception 13 à la suite de l'émission. Les vecteurs d'étalonnage $V_E$ sont exprimés sous la forme de la fonction (3) suivante :

$$V_E = \left\{ y_{0,n}(\theta_i, PR_j, f_k, pol_l) \right\}_{n=1,...,N} \qquad (3)$$

où les notations sont celles de la fonction (2).

L'ensemble des tables d'étalonnage forme un espace de solutions. Les caractéristiques de l'onde incidente sur le système de réception 22 sont recherchées dans un tel espace de solutions.

Le système de traitement numérique rapide 27 intègre, par exemple, des composants tels que des circuits logiques programmables (FPGA) intégrant des firmwares. Un firmware, aussi appelé micrologiciel ou microcode, est un ensemble d'instructions et de structures de données.

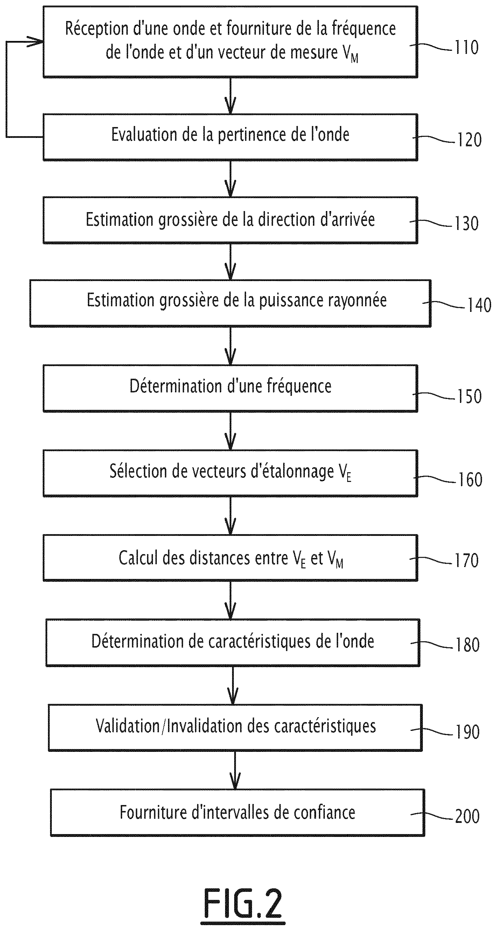

De tels composants sont configurés pour mettre en œuvre les étapes 130 à 200 de l'organigramme illustré en figure 2 et qui seront décrites plus en détails dans la suite de la description.

Le fonctionnement du dispositif 10 selon le premier mode de réalisation est maintenant décrit en référence à la figure 2, qui illustre schématiquement un premier exemple de mise en œuvre d'un procédé de détermination de caractéristiques d'une onde électromagnétique.

Initialement, le procédé de détermination comprend une étape 110 de réception d'une onde électromagnétique sur le système de réception 22.

Chaque voie de réception 13 fournit alors une valeur mesurée de puissance $y_{M,n}$, l'ensemble des valeurs mesurées de puissance $y_{M,n}$ formant les composantes du vecteur de mesure $V_M$.

Les voies de réception 13 permettent également de mesurer la fréquence de l'onde reçue sur le système de réception 22.

Puis, le procédé de détermination comprend une étape 120 d'évaluation, par le déclencheur 16, de la pertinence de l'onde reçue.

Pour cela, chaque valeur mesurée de puissance $y_{M,n}$ est comparée au seuil de détection.

Lorsqu'au moins une valeur mesurée de puissance $y_{M,n}$ est supérieure ou égale au seuil de détection, les étapes suivantes du procédé sont mises en œuvre.

Sinon, les valeurs mesurées de puissance $y_{M,n}$ sont considérées comme trop faibles et les étapes suivantes du procédé ne sont pas mises en œuvre.

Dans ce qui suit, les étapes suivantes 130 à 200 du procédé sont mises en œuvre par le système de traitement numérique rapide 27.

Le procédé de détermination comprend, ensuite, une étape 130 d'estimation de la direction d'arrivée grossière de l'onde incidente sur le système de réception 22.

La direction d'arrivée grossière est estimée à partir des valeurs mesurées de puissance $y_{M,n}$ et d'un algorithme usuellement utilisé dans le domaine de la radiogoniométrie d'amplitude.

Le procédé de détermination comprend, également, une étape 140 d'estimation de la puissance rayonnée grossière de l'onde incidente sur le système de réception 22.

La puissance rayonnée grossière de l'onde incidente est estimée à partir du maximum des valeurs mesurées de puissance $y_{M,n}$.

Le procédé de détermination comprend, également, une étape 150 de détermination dans les tables d'étalonnage de la valeur discrète de fréquence la plus proche de la valeur de fréquence mesurée. Une telle valeur de fréquence déterminée est appelée valeur déterminée de fréquence. La valeur déterminée de fréquence est utilisée pour réduire l'espace de solutions. En revanche, la fréquence de l'onde reçue est considérée être la fréquence obtenue en sortie des voies de réception 13.

Le procédé de détermination comprend, alors, une étape 160 de sélection de vecteurs d'étalonnage $V_E$ dans les tables d'étalonnage. L'étape de sélection 160 consiste à réduire l'espace de solutions formé par les tables d'étalonnage.

Ainsi, seuls sont considérés dans la suite du procédé, les vecteurs d'étalonnage $V_E$ sélectionnés. Les vecteurs d'étalonnage $V_E$ sélectionnés sont les vecteurs d'étalonnage $V_E$ dépendant de : la valeur déterminée de fréquence, d'une valeur de puissance rayonnée comprise au sens large dans un intervalle de puissance rayonnée centré autour de la puissance rayonnée grossière estimée et d'une valeur de direction d'arrivée comprise au sens large dans un intervalle de direction d'arrivée centré autour de la direction d'arrivée grossière estimée. L'intervalle de direction d'arrivée est, par exemple, centré à $\pm$ 5° autour de la direction d'arrivée grossière.

Le procédé de détermination comprend, ensuite, une étape 170 de calcul de la distance $\Delta$ entre le vecteur de mesure $V_M$ et chaque vecteur d'étalonnage $V_E$ de l'espace réduit de solutions. La distance $\Delta$ calculée est, par exemple, la distance euclidienne, donnée par l'équation (4) suivante :

$$\Delta = \sqrt{\sum_{n=1}^{N}(y_{M,n} - y_{0,n}(\theta_i, PR_j, f_k, pol_l))^2} \qquad (4)$$

où les notations sont celles de la fonction (2).

Le procédé de détermination comprend, ensuite, une étape 180 de détermination de caractéristiques de l'onde incidente. Les caractéristiques de l'onde incidente sont les caractéristiques du vecteur de calibration $V_E$ pour lequel la distance $\Delta$ calculée est minimale et égale à $\Delta_0$.

Puis, le procédé de détermination comprend une étape 190 de comparaison de la distance minimale $\Delta_0$ à un

seuil en distance.

Lorsque la distance minimale $\Delta_0$ est inférieure ou égale au seuil en distance, les caractéristiques déterminées lors de l'étape de détermination 180 sont validées et jugées vraisemblables.

Par contre, lorsque la distance minimale $\Delta_0$ est strictement supérieure au seuil en distance, les caractéristiques déterminées lors de l'étape de détermination 180 sont invalidées et jugées invraisemblables. Dans ce cas, il est probable que l'onde incidente sur le système de réception 22 soit issue du mélange de signaux provenant, par exemple, de réflexions parasites de l'onde sur une structure proche du système de réception 22.

Le procédé de détermination comprend également une étape 200 de fourniture d'un intervalle de confiance pour au moins l'une des caractéristiques déterminées.

Pour cela, une tolérance est ajoutée à la distance minimale $\Delta_0$ de sorte à définir un intervalle de distance ayant pour borne inférieure la distance minimale $\Delta_0$ et pour borne supérieure la distance minimale $\Delta_0$ plus la tolérance.

L'intervalle de confiance sur la puissance rayonnée de l'onde incidente a pour borne inférieure la puissance rayonnée minimale parmi les valeurs de puissances rayonnées associées aux distances $\Delta$ comprises dans l'intervalle de distance et pour borne supérieure la puissance rayonnée maximale parmi les valeurs de puissances rayonnées associées aux distances $\Delta$ comprises dans l'intervalle de distance.

De même, l'intervalle de confiance sur la direction d'arrivée de l'onde incidente a pour borne inférieure la direction d'arrivée minimale parmi les valeurs de directions d'arrivée associées aux distances $\Delta$ comprises dans l'intervalle de distance et pour borne supérieure la direction d'arrivée maximale parmi les valeurs de direction d'arrivée associées aux distances $\Delta$ comprises dans l'intervalle de distance.

Dans le cas de la polarisation, la polarisation la plus probable est la polarisation la plus fréquente parmi les polarisations associées aux distances $\Delta$ comprises dans l'intervalle de distance.

Ainsi, le procédé décrit met en œuvre un traitement numérique, associé à un système de goniométrie à plusieurs antennes, permettant d'estimer la direction d'arrivée, la puissance rayonnée et la polarisation les plus vraisemblables pour une onde initialement inconnue.

La précision de la direction d'arrivée déterminée est améliorée du fait de l'utilisation de tables d'étalonnage prenant en compte les variations de la puissance en sortie de chaque voie de réception 13 en fonction de valeurs de direction d'arrivée, de fréquence, de puissance rayonnée et de polarisation.

En outre, un tel procédé permet également de déterminer précisément la puissance rayonnée de l'onde incidente et de déterminer la tendance de la polarisation la plus vraisemblable.

La sélection de vecteurs d'étalonnage $V_E$ parmi l'ensemble des vecteurs d'étalonnage $V_E$ permet de réduire l'espace de solutions formé par les tables d'étalonnage. Cela permet, ainsi, de diminuer les temps de calcul en considérant uniquement les caractéristiques de l'espace de solutions les plus vraisemblables.

La validation ou l'invalidation des caractéristiques déterminées par comparaison de la distance minimale $\Delta_0$ à un seuil de distance permet d'écarter les ondes incidentes qui seraient issues de la superposition de plusieurs signaux et notamment de réflexions parasites.

En outre, la fourniture d'un intervalle de confiance pour les valeurs de puissance et de directions d'arrivée déterminées permet d'évaluer la fiabilité des caractéristiques déterminées.

Selon un deuxième mode de réalisation du dispositif 10, les éléments identiques aux éléments du dispositif 10 du premier mode de réalisation ne sont pas répétés. Seules les différences sont mises en évidence.

Dans ce deuxième mode de réalisation, les tables d'étalonnage mémorisées dans la mémoire 26 ont été constituées à partir de l'émission répétée P fois sur le système de réception 22, d'ondes électromagnétiques ayant chacune un même quadruplet de caractéristiques connues. Le quadruplet de caractéristiques connues pour chaque onde comprend la puissance rayonnée de l'onde reçue, la fréquence de l'onde reçue, la polarisation de l'onde reçue et la direction d'arrivée de l'onde reçue.

Chaque nouvelle réception d'une onde de même quadruplet de caractéristiques connues forme un tirage. Chaque tirage correspond à des valeurs de bruits thermiques et de bruits d'étalonnage potentiellement différents d'un tirage à un autre.

Pour chaque quadruplet de caractéristiques connues, à l'issu de l'ensemble des P tirages, il est obtenu un nombre P de vecteurs d'étalonnage $V_E$ ayant pour éléments les valeurs étalonnées de puissance $y_{0,n}$ en sortie de chaque voie de réception 13.

Parmi, les vecteurs d'étalonnage $V_E$ obtenus pour un même quadruplet, certains étant susceptibles d'être égaux, le nombre Q de vecteurs d'étalonnage $V_E$ différents pour un même quadruplet de caractéristiques connus est inférieur ou égal au nombre P de tirages.

Chaque vecteur d'étalonnage $V_E$ est alors associé à un nombre d'occurrences $h_q$, q variant de 1 à Q, représentatif du nombre de fois où le vecteur d'étalonnage $V_E$ est obtenu pour chaque quadruplet de caractéristiques connues. Pour chaque quadruplet de caractéristiques connues, les vecteurs d'étalonnage $V_E$ sont, par exemple, exprimés sous la forme de la fonction (5) suivante :

$$V_E = \left\{ \left\{ \left\{ y_{0,n} \right\}_q , h_q \right\}_{n=1,\ldots,N} \right\}_{q=1,\ldots,Q} \qquad (5)$$

De ce fait, les tables d'étalonnage comprennent, pour chaque quadruplet de caractéristiques connues, un histogramme représentatif de l'occurrence de chaque vecteur d'étalonnage $V_E$ obtenu. Les histogrammes sont, par exemple, exprimés sous la forme de la fonction (6) suivante :

$$H = \left\{ \left\{ \left\{ y_{0,n} \right\}_q , h_q \right\}_{n=1,\ldots,N} \left( \theta_i, PR_j, f_k, pol_l \right) \right\}_{q=1,\ldots,Q} \qquad (6)$$

où les notations sont celles de la fonction (2).

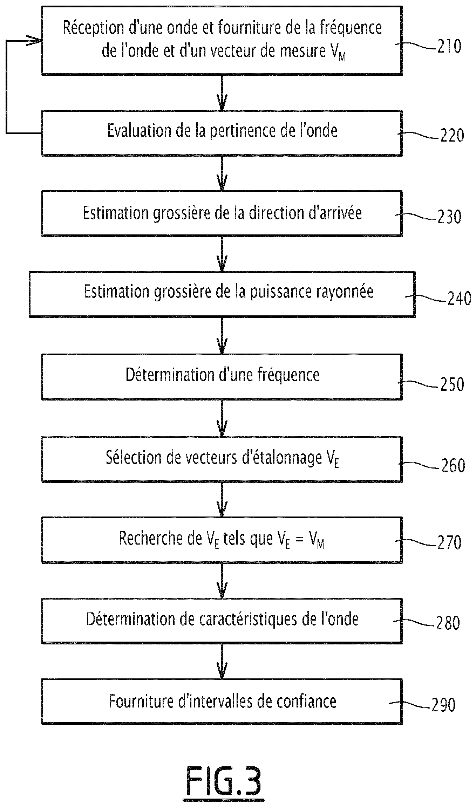

Les composants du système de traitement numérique rapide 27 sont configurés pour mettre en œuvre les étapes 230 à 290 de l'organigramme illustré en figure 3 et qui sera décrit plus en détails dans la suite de la description.

Le fonctionnement du dispositif 10 selon le deuxième mode de réalisation est maintenant décrit.

Le procédé de détermination selon le deuxième mode de réalisation comprend des étapes de réception 210, d'évaluation 220, d'estimation 230 de la direction d'arrivée grossière, de détermination 240 de la puissance rayonnée grossière, de détermination 250 d'une fréquence et de sélection 260 identiques, respectivement, aux étapes de réception 110, d'évaluation 120, d'estimation 130 de la direction d'arrivée grossière, d'estimation 140 de la puissance rayonnée grossière, de détermination 150 d'une fréquence et de sélection 160, du procédé de détermination selon le premier mode de réalisation.

Le procédé de détermination comprend, en outre, une étape 270 de recherche dans les tables d'étalonnage des vecteurs d'étalonnage $V_E$ égaux au vecteur de mesure $V_M$. Deux vecteurs sont considérés égaux lorsque les composantes de ces vecteurs sont égales avec une tolérance prédéterminée.

Ensuite, le procédé comprend une étape 280 de détermination de caractéristiques de l'onde incidente à partir des vecteurs d'étalonnage $V_E$ obtenus lors de l'étape de recherche 270.

Lorsque aucun vecteur d'étalonnage $V_E$ n'est égal au vecteur de mesure $V_M$, il n'est pas possible de déterminer les caractéristiques de l'onde incidente à partir des tables d'étalonnage. Cela indique que l'onde incidente résulte probablement de la superposition de signaux et notamment de réflexions parasites.

Lorsque un ou plusieurs vecteurs d'étalonnage $V_E$ sont égaux au vecteur de mesure $V_M$, les caractéristiques de l'onde incidente sont les caractéristiques du vecteur d'étalonnage $V_E$ pour lequel le nombre d'occurrences $h_q$ est maximal.

Dans ce cas, le procédé de détermination comprend une étape 290 de fourniture d'un intervalle de confiance pour au moins l'une des caractéristiques estimées.

L'intervalle de confiance pour les puissances rayonnées a pour bornes les valeurs extrêmes de puissance rayonnée parmi les puissances rayonnées associées aux vecteurs d'étalonnage $V_E$ obtenus à l'issu de l'étape de recherche 270.

De même, l'intervalle de confiance pour les directions d'arrivée a pour bornes les valeurs extrêmes de direction d'arrivée parmi les directions d'arrivée associées aux vecteurs d'étalonnage $V_E$ obtenus à l'issu de l'étape de recherche 270.

Chaque intervalle de confiance est affecté d'un indice d'occurrence relatif à la probabilité d'obtenir le vecteur d'étalonnage $V_E$ quel que soit le quadruplet de caractéristiques associé au vecteur d'étalonnage $V_E$. L'indice d'occurrence est calculé à partir des nombres d'occurrences $h_q$ des vecteurs d'étalonnage $V_E$ obtenus à l'issu de l'étape de recherche 270.

La polarisation la plus probable est la polarisation la plus fréquente parmi les polarisations associées aux vecteurs d'étalonnage $V_E$ obtenus à l'issu de l'étape de recherche 270.

Outre les avantages décrits pour le premier mode de réalisation, le deuxième mode de réalisation permet, par la réalisation de plusieurs tirages, de prendre en compte les variations dues aux bruits thermiques additifs dans chaque voie de réception 13 et les erreurs résiduelles d'étalonnage. Cela améliore ainsi la précision dans la détermination de caractéristiques de l'onde incidente.

## Revendications

1. Procédé de détermination de caractéristiques d'une onde électromagnétique reçue par un système de réception (22), le système de réception (22) comprenant au moins deux voies de réception (13), chaque voie de réception (13) comprenant une antenne (21) et une chaîne de réception (14), chaque chaîne de réception (14) étant propre à délivrer une valeur représentative de la puissance délivrée par l'antenne (21) correspondante suite à la réception de l'onde par le système de réception (22), les caractéristiques comprenant au moins la direction d'arrivée de l'onde reçue, le procédé comprenant une étape de :

- fourniture (110 ; 210) d'un vecteur de mesure ($V_M$) ayant pour éléments les valeurs représentatives de la puissance délivrée par l'antenne (21) de chaque voie de réception (13) suite à la réception de l'onde sur le système de réception (22),

**caractérisé en ce que** le procédé comprend, en outre, les étapes de :

- comparaison (170; 270) du vecteur de mesure ($V_M$) à des vecteurs d'étalonnage ($V_E$), les vecteurs d'étalonnage ($V_E$) étant contenus dans des tables d'étalonnage constituées à partir de l'émission, sur le système de réception (22), d'ondes électromagnétiques ayant chacune un ensemble de caractéristiques connues, chaque émission permettant d'obtenir un vecteur d'étalonnage ($V_E$), chaque vecteur d'étalonnage ($V_E$) ayant pour éléments des valeurs représentatives de la puissance délivrée par l'antenne (21) de chaque voie de réception (13) en fonction d'un ensemble de caractéristiques connues, et
- détermination (180 ; 280) des caractéristiques de l'onde reçue sur le système de réception (22) à partir du résultat de la comparaison,

chaque vecteur d'étalonnage ($V_E$) étant fonction d'une valeur de direction d'arrivée contenue dans les tables d'étalonnage, le procédé comprenant une étape (130 ; 230) d'estimation de la direction d'arrivée grossière de l'onde reçue par le système de réception (22) pour obtenir au moins une valeur de direction d'arrivée grossière, le procédé comprenant, en outre, une étape (160 ; 260) de sélection des vecteurs d'étalonnage ($V_E$) ayant pour éléments les valeurs représentatives de puissance délivrée fonction de valeurs de direction d'arrivée comprises au sens large dans un intervalle de direction d'arrivée centré autour de la direction d'arrivée grossière,

**caractérisé en ce que** chaque vecteur d'étalonnage ($V_E$) des tables d'étalonnage est associé à un nombre d'occurrences ($h_q$) représentatif du nombre de fois où le vecteur d'étalonnage ($V_E$) est obtenu pour un même ensemble de caractéristiques connues, l'étape de comparaison (270) comprenant une phase de recherche dans les tables d'étalonnage des vecteurs d'étalonnage ($V_E$) égaux au vecteur de mesure ($V_M$) avec une tolérance prédéterminée, les caractéristiques de l'onde, déterminées lors de l'étape de détermination (180 ; 280), étant les caractéristiques du vecteur d'étalonnage ($V_E$) pour lequel le nombre d'occurrences ($h_q$) est maximal parmi les vecteurs d'étalonnage ($V_E$) obtenus lors de la phase de recherche.

2. Procédé selon la revendication 1, dans lequel, pour chaque onde reçue, l'ensemble des caractéristiques connues comprend une ou plusieurs des caractéristiques choisies parmi une valeur de puissance rayonnée, une valeur de fréquence, une valeur de direction d'arrivée et une valeur de polarisation.

3. Procédé selon la revendication 1 ou 2, dans lequel chaque vecteur d'étalonnage ($V_E$) est fonction d'une valeur de fréquence contenue dans les tables d'étalonnage, le procédé comprenant une étape (110, 210) de fourniture de la fréquence de l'onde reçue par le système de réception (22) et de détermination (150 ; 250) de la fréquence, parmi les fréquences des tables d'étalonnage, la plus proche de la fréquence fournie, le procédé comprenant, en outre, une étape (160 ; 260) de sélection des vecteurs d'étalonnage ($V_E$) ayant pour éléments les valeurs représentatives de puissance délivrée fonction de la fréquence déterminée.

4. Procédé selon l'une quelconque des revendications 1 à 3, dans lequel chaque vecteur d'étalonnage ($V_E$) est fonction d'une valeur de puissance rayonnée contenue dans les tables d'étalonnage, le procédé comprenant une étape (140 ; 240) d'estimation de la puissance rayonnée grossière de l'onde reçue par le système de réception (22), le procédé comprenant, en outre, une étape (160 ; 260) de sélection des vecteurs d'étalonnage ($V_E$) ayant pour éléments les valeurs représentatives de puissance délivrée fonction de valeurs de puissance rayonnée comprises au sens large dans un intervalle de puissance rayonnée centré autour de la puissance rayonnée grossière.

5. Procédé selon l'une quelconque des revendications 1 à 4, dans lequel l'étape de comparaison (170) comprend le calcul de distances ($\Delta$) entre le vecteur de mesure ($V_M$) et des vecteurs d'étalonnage ($V_E$) des tables d'étalonnage, les caractéristiques de l'onde déterminées lors de l'étape de détermination (180 ; 280) étant les caractéristiques du vecteur d'étalonnage ($V_E$) pour lequel la distance ($\Delta$) calculée est minimale.

6. Procédé selon la revendication 5, dans lequel le procédé comprend, en outre, une étape (190) de comparaison de

la distance minimale ($\Delta_0$) calculée à un seuil de distance et d'invalidation des caractéristiques déterminées lorsque la distance minimale ($\Delta_0$) calculée est strictement supérieure au seuil de distance.

7. Procédé selon l'une quelconque des revendications 5 ou 6, dans lequel le procédé comprend, également, une étape de fourniture (200) d'un intervalle de confiance pour au moins l'une des caractéristiques déterminées, l'intervalle de confiance de la ou des caractéristiques déterminées ayant pour bornes les valeurs extrêmes de la caractéristique parmi les valeurs de la caractéristique associées à des distances ($\Delta$) calculées comprises dans un intervalle de distance, l'intervalle de distance ayant pour borne inférieure la distance minimale ($\Delta_0$) calculée et pour borne supérieure la distance minimale ($\Delta_0$) calculée plus une tolérance.

8. Procédé selon l'une quelconque des revendications 1 à 7, dans lequel lorsque un ou plusieurs vecteurs d'étalonnage ($V_E$) sont obtenus à la suite de la phase de recherche, le procédé comprend, également, une étape (290) de fourniture d'un intervalle de confiance pour au moins l'une des caractéristiques déterminées, l'intervalle de confiance de la ou des caractéristiques déterminées ayant pour bornes les valeurs extrêmes de la caractéristique parmi les valeurs de la caractéristique associées aux vecteurs d'étalonnage ($V_E$) obtenus lors de la phase de recherche.

9. Dispositif (10) de détermination de caractéristiques d'une onde électromagnétique reçue par un système de réception (22), le système de réception (22) comprenant au moins deux voies de réception (13), chaque voie de réception (13) comprenant une antenne (21) et une chaîne de réception (14), chaque chaîne de réception (14) étant propre à délivrer une valeur représentative de la puissance délivrée par l'antenne (21) correspondante suite à la réception de l'onde par le système de réception (22), les caractéristiques comprenant au moins la direction d'arrivée de l'onde reçue, le dispositif (10) étant configuré à mettre en œuvre les étapes du procédé selon l'une quelconque des revendications 1 à 8.

## Patentansprüche

1. Verfahren zum Bestimmen von Charakteristiken einer elektromagnetischen Welle, die von einem Empfangssystem (22) empfangen wird, das Empfangssystem (22) umfassend mindestens zwei Empfangskanäle (13), jeder Empfangskanal (13) umfassend eine Antenne (21) und eine Empfangskette (14), wobei jede Empfangskette (14) geeignet ist, um einen Wert bereitzustellen, der repräsentativ für die von der entsprechenden Antenne (21) bereitgestellte Leistung nach dem Empfang der Welle durch das Empfangssystem (22) ist, die Charakteristiken umfassend mindestens die Ankunftsrichtung der empfangenen Welle, das Verfahren umfassend einen Schritt zum:

- Bereitstellen (110; 210) eines Messvektors ($V_M$), der als Elemente die Werte aufweist, die repräsentativ für die Leistung sind, die von der Antenne (21) von jedem Empfangskanal (13) nach dem Empfang der Welle auf dem Empfangssystem (22) bereitgestellt wird,

dadurch gekennzeichnet, dass das Verfahren ferner die folgenden Schritte umfasst:

- Vergleichen (170; 270) des Messvektors ($V_M$) mit Kalibrierungsvektoren ($V_E$), wobei die Kalibrierungsvektoren ($V_E$) in Kalibrierungstabellen enthalten sind, die anhand der Aussendung von elektromagnetischen Wellen, die jeweils eine Gruppe bekannter Charakteristiken aufweisen, an das Empfangssystem (22) gebildet werden, es jede Aussendung ermöglicht, einen Kalibrierungsvektor ($V_E$) zu erlangen, wobei jeder Kalibrierungsvektor ($V_E$) als Elemente Werte aufweist, die repräsentativ für die von der Antenne (21) von jedem Empfangskanal (13) bereitgestellte Leistung abhängig von einem Satz bekannter Charakteristiken sind, und
- Bestimmen (180; 280) von Charakteristiken der empfangenen Welle auf dem Empfangssystem (22) anhand des Resultats des Vergleichs,

wobei jeder Kalibrierungsvektor ($V_E$) von einem Ankunftsrichtungswert abhängig ist, der in den Kalibrierungstabellen enthalten ist, das Verfahren umfassend einen Schritt (130; 230) zum Schätzen der groben Ankunftsrichtung der von dem Empfangssystem (22) empfangenen Welle, um mindestens einen groben Ankunftsrichtungswert zu erlangen, das Verfahren ferner umfassend einen Schritt (160; 260) zum Auswählen von Kalibrierungsvektoren ($V_E$), die als Elemente die repräsentativen Werte der bereitgestellten Leistung aufweisen, die von Ankunftsrichtungswerten abhängen, die im weitesten Sinne in einem Ankunftsrichtungsintervall sind, das um die grobe Ankunftsrichtung zentriert ist,
dadurch gekennzeichnet, dass mit jedem Kalibrierungsvektor ($V_E$) der Kalibrierungstabellen eine Anzahl von Vorkommen ($h_q$) assoziiert ist, die repräsentativ für die Anzahl von Malen ist, die der Kalibrierungsvektor

($V_E$) für einen gleichen Satz bekannter Charakteristiken erlangt wird, wobei der Vergleichsschritt (270) eine Phase umfasst, in der in den Kalibrierungstabellen nach Kalibrierungsvektoren ($V_E$) gesucht wird, die gleich wie der Messvektor ($V_M$) mit einer vorbestimmten Toleranz sind, wobei die Charakteristiken der Welle, die in dem Bestimmungsschritt (180; 280) bestimmt werden, die Charakteristiken des Kalibrierungsvektors ($V_E$) sind, für den die Anzahl des Vorkommens ($h_q$) unter den in der Suchphase erlangten Kalibrierungsvektoren ($V_E$) maximal ist.

2. Verfahren nach Anspruch 1, wobei für jede empfangene Welle die Gesamtheit der bekannten Charakteristiken eine oder mehrere der Charakteristiken umfasst, die ausgewählt sind aus einem Wert für die abgestrahlte Leistung, einem Frequenzwert, einem Wert für die Ankunftsrichtung und einem Polarisationswert.

3. Verfahren nach Anspruch 1 oder 2, wobei jeder Kalibrierungsvektor ($V_E$) abhängig von einem Frequenzwert ist, der in den Kalibrierungstabellen enthalten ist, das Verfahren umfassend einen Schritt (110, 210) eines Bereitstellens der Frequenz der von dem Empfangssystem (22) empfangenen Welle und eines Bestimmens (150; 250) der Frequenz unter den Frequenzen der Kalibrierungstabellen, die der gelieferten Frequenz am nächsten kommt, das Verfahren ferner umfassend einen Schritt (160; 260) zum Auswählen der Kalibrierungsvektoren ($V_E$), die als Elemente die repräsentativen Werte der bereitgestellten Leistung abhängig von der bestimmten Frequenz aufweisen.

4. Verfahren nach einem der Ansprüche 1 bis 3, wobei jeder Kalibrierungsvektor ($V_E$) von einem Strahlungsleistungswert abhängt, der in den Kalibrierungstabellen enthaltenen, das Verfahren umfassend einen Schritt (140; 240) zum Schätzen der groben Strahlungsleistung der von dem Empfangssystem (22) empfangenen Welle, das Verfahren ferner umfassend einen Schritt (160; 260) zum Auswählen von Kalibrierungsvektoren ($V_E$), die als Elemente die repräsentativen Werte der bereitgestellten Leistung abhängig von Werten der abgestrahlten Leistung aufweisen, die im weitesten Sinne in einem Intervall der abgestrahlten Leistung enthalten sind, das um die grobe abgestrahlte Leistung zentriert ist.

5. Verfahren nach einem der Ansprüche 1 bis 4, wobei der Vergleichsschritt (170) das Berechnen von Abständen (4) zwischen dem Messvektor ($V_M$) und Kalibrierungsvektoren ($V_E$) der Kalibriertabellen umfasst, wobei die in dem Bestimmungsschritt (180; 280) bestimmten Charakteristiken der Welle die Charakteristiken des Kalibrierungsvektors ($V_E$) sind, bei dem der berechnete Abstand ($\Delta$) minimal ist.

6. Verfahren nach Anspruch 5, wobei das Verfahren ferner einen Schritt (190) umfasst, bei dem der berechnete Mindestabstand ($\Delta_0$) mit einem Abstandsschwellenwert verglichen wird und die ermittelten Charakteristiken ungültig gemacht werden, wenn der berechnete Mindestabstand ($\Delta_0$) strikt über dem Abstandsschwellenwert ist.

7. Verfahren nach einem der Ansprüche 5 oder 6, wobei das Verfahren auch einen Schritt eines Bereitstellens (200) eines Konfidenzintervalls für mindestens eine der bestimmten Charakteristiken umfasst, wobei das Konfidenzintervall der einen oder der mehreren bestimmten Charakteristiken die Extremwerte des Merkmals unter den Werten des Merkmals, die mit berechneten Abständen ($\Delta$) assoziiert sind, die in einem Abstandsintervall liegen, als Grenzen hat, wobei das Abstandsintervall den berechneten Mindestabstand ($\Delta_0$) als untere Grenze und den berechneten Mindestabstand $\Delta_0$) plus eine Toleranz als obere Grenze hat.

8. Verfahren nach einem der Ansprüche 1 bis 7, wobei, wenn als Resultat der Suchphase ein oder mehrere Kalibrierungsvektoren ($V_E$) erlangt werden, das Verfahren auch einen Schritt (290) eines Bereitstellens eines Konfidenzintervalls für mindestens eine der bestimmten Charakteristiken umfasst, wobei das Konfidenzintervall der einen oder der mehreren bestimmten Charakteristiken die Extremwerte des Merkmals unter den Werten der Charakteristik, die mit den in der Suchphase erlangten Kalibrierungsvektoren ($V_E$) assoziiert sind, als Grenzen hat.

9. Vorrichtung (10) zum Bestimmen von Charakteristiken einer elektromagnetischen Welle, die von einem Empfangssystem (22) empfangen wird, das Empfangssystem (22) umfassend mindestens zwei Empfangskanäle (13), jeder Empfangskanal (13) umfassend eine Antenne (21) und eine Empfangskette (14), wobei jede Empfangskette (14) geeignet ist, um einen Wert bereitzustellen, der repräsentativ für die von der entsprechenden Antenne (21) bereitgestellte Leistung nach dem Empfang der Welle durch das Empfangssystem (22) ist, die Charakteristiken umfassend mindestens die Ankunftsrichtung der empfangenen Welle, wobei die Vorrichtung (10) konfiguriert ist, um die Schritte des Verfahrens nach einem der Ansprüche 1 bis 8 durchzuführen.

**Claims**

1.  A method for determining features of an electromagnetic wave received by a reception system (22), the reception system (22) comprising at least two reception channels (13), each reception channel (13) comprising an antenna (21) and a reception chain (14), each reception chain (14) being capable of delivering a value representative of the power delivered by the corresponding antenna (21) after reception of the wave by the reception system (22), the features comprising at least the direction of arrival of the received wave, the method comprising a step of:

    - providing (110; 210) a measurement vector ($V_M$) having, as elements, the values representative of the power delivered by the antenna (21) of each reception channel (13) following the reception of the wave on the reception system (22),

    **characterized in that** the method further comprises the following steps:

    - comparing (170; 270) the measurement vector ($V_M$) to calibration vectors ($V_E$), the calibration vectors ($V_E$) being contained in calibration tables formed from the emission, on the reception system (22), of electromagnetic waves each having a set of known features, each emission making it possible to obtain a calibration vector ($V_E$), each calibration vector ($V_E$) having, as elements, values representative of the power delivered by the antenna (21) of each reception channel (13) as a function of a set of known features, and
    - determining (180; 280) features of the wave received on the reception system (22) from the result of the comparison,

    each calibration vector ($V_E$) being a function of a direction of arrival value contained in the calibration tables, the method comprising a step (130; 230) for estimating the rough direction of arrival of the wave received by the reception system (22) to obtain at least one rough direction of arrival value, the method further comprising a step (160; 260) for selecting calibration vectors ($V_E$) having, as elements, the values representative of delivered power as a function of direction of arrival values comprised broadly speaking in a direction of arrival interval centered around the rough direction of arrival,
    **characterized in that** each calibration vector ($V_E$) of the calibration tables is associated with a number of occurrences ($h_q$) representative of the number of times where the calibration vector ($V_E$) is obtained for a same set of known features, the comparison step (270) comprising a phase for searching, in the calibration tables, for calibration vectors ($V_E$) equal to the measurement vector ($V_M$) with a predetermined tolerance, the features of the wave, determined during the determination step (180; 280), being the features of the calibration vector ($V_E$) for which the number of occurrences ($h_q$) is maximal from among the calibration vectors ($V_E$) obtained during this search phase.

2.  The method according to claim 1, wherein, for each received wave, the set of known features comprises one or several features chosen from among a radiated power value, a frequency value, a direction of arrival value and a polarization value.

3.  The method according to claim 1 or 2, wherein each calibration vector ($V_E$) is a function of a frequency value contained in the calibration tables, the method comprising a step (110; 210) for providing the frequency of the wave received by the reception system (22) and determining (150; 250) the frequency, from among the frequencies of the calibration tables, closest to the provided frequency, the method further comprising a step (160; 260) for selecting calibration vectors ($V_E$) having, as elements, the values representative of delivered power as a function of the determined frequency.

4.  The method according to any one of claims 1 to 3, wherein each calibration vector ($V_E$) is a function of a radiated power value contained in the calibration tables, the method comprising a step (140; 240) for estimating the rough radiated power of the wave received by the reception system (22), the method further comprising a step (160; 260) for selecting calibration vectors ($V_E$) having, as elements, the values representative of delivered power as a function of radiated power values comprised broadly speaking in a radiated power interval centered around the rough radiated power.

5.  The method according to any one of claims 1 to 4, wherein the comparison step (170) comprises calculating distances ($\varDelta$) between the measurement vector ($V_M$) and calibration vectors ($V_E$) of the calibration tables, the features of the wave determined during the determination step (180; 280) being the features of the calibration vector ($V_E$) for which the calculated distance ($\varDelta$) is minimal.

6. The method according to claim 5, wherein the method further comprises a step (190) for comparing the calculated minimum distance ($\Delta_0$) to a distance threshold and invalidating determined features when the calculated minimum distance ($\Delta_0$) is strictly greater than the distance threshold.

7. The method according to any one of claims 5 or 6, wherein the method also comprises a step for providing (200) a confidence interval for at least one of the determined features, the confidence interval of the determined feature(s) having, as boundaries, the extreme values of the feature from among the values of the feature associated with calculated distances ($\Delta$) comprised in a distance interval, the distance interval having, as lower boundary, the calculated minimum distance ($\Delta_0$) and, as upper boundary, the calculated minimum distance ($\Delta_0$) plus a tolerance.

8. The method according to any one of claims 1 to 7, wherein when one or several calibration vectors ($V_E$) are obtained following the search phase, the method also comprises a step (290) for providing a confidence interval for at least one of the determined features, the confidence interval of the determined feature(s) having, as boundaries, the extreme values of the feature from among the values of the feature associated with the calibration vectors ($V_E$) obtained during the search phase.

9. A device (10) for determining features of an electromagnetic wave received by a reception system (22), the reception system (22) comprising at least two reception channels (13), each reception channel (13) comprising an antenna (21) and a reception chain (14), each reception chain (14) being capable of delivering a value representative of the power delivered by the corresponding antenna (21) after reception of the wave by the reception system (22), the features comprising at least the direction of arrival of the received wave, the device (10) being configured to carry out the steps of the method according to any one of claims 1 to 8.

FIG.1

Réception d'une onde et fourniture de la fréquence de l'onde et d'un vecteur de mesure $V_M$ — 110

Evaluation de la pertinence de l'onde — 120

Estimation grossière de la direction d'arrivée — 130

Estimation grossière de la puissance rayonnée — 140

Détermination d'une fréquence — 150

Sélection de vecteurs d'étalonnage $V_E$ — 160

Calcul des distances entre $V_E$ et $V_M$ — 170

Détermination de caractéristiques de l'onde — 180

Validation/Invalidation des caractéristiques — 190

Fourniture d'intervalles de confiance — 200

FIG.2

Réception d'une onde et fourniture de la fréquence de l'onde et d'un vecteur de mesure $V_M$ ——210

Evaluation de la pertinence de l'onde ——220

Estimation grossière de la direction d'arrivée ——230

Estimation grossière de la puissance rayonnée ——240

Détermination d'une fréquence ——250

Sélection de vecteurs d'étalonnage $V_E$ ——260

Recherche de $V_E$ tels que $V_E = V_M$ ——270

Détermination de caractéristiques de l'onde ——280

Fourniture d'intervalles de confiance ——290

## FIG.3